Europäisches Patentamt

European Patent Office

Office européen des brevets

(19)

(11) **EP 1 260 845 A2**

(12) **EUROPÄISCHE PATENTANMELDUNG**

| | |
|---|---|
| (43) Veröffentlichungstag:<br> **27.11.2002 Patentblatt 2002/48** | (51) Int Cl.⁷: $G02B\ 17/08$ |

(21) Anmeldenummer: **02010551.6**

(22) Anmeldetag: **10.05.2002**

| | |
|---|---|
| (84) Benannte Vertragsstaaten:<br>**AT BE CH CY DE DK ES FI FR GB GR IE IT LI LU MC NL PT SE TR**<br>Benannte Erstreckungsstaaten:<br>**AL LT LV MK RO SI** | (72) Erfinder:<br>• **Epple, Alexander**<br> **73431 Aalen (DE)**<br>• **Beierl, Helmut**<br> **89522 Heidenheim (DE)** |
| (30) Priorität: **22.05.2001 DE 10127227** | (74) Vertreter: **Patentanwälte**<br>**Ruff, Wilhelm, Beier, Dauster & Partner**<br>**Kronenstrasse 30**<br>**70174 Stuttgart (DE)** |
| (71) Anmelder: **CARL ZEISS SEMICONDUCTOR MANUFACTURING TECHNOLOGIES AG**<br>**73447 Oberkochen (DE)** | |

(54) **Katadioptrisches Reduktionsobjektiv**

(57) Ein katadioptrisches Projektionsobjektiv ist dazu ausgebildet, ein in einer Objektebene (2) angeordnetes Muster unter Erzeugung eins einzigen reellen Zwischenbildes (3) in eine Bildebene (4) abzubilden. Zwischen der Objektebene und der Bildebene liegen ein katadioptrischer erster Objektivteil (5) mit einem Konkavspiegel (6) und einer Strahlumlenkeinrichtung (7) sowie ein hinter der Strahlumlenkeinrichtung beginnender dioptrischer zweiter Objektivteil (8). Das System ist so ausgelegt, dass das Zwischenbild hinter der ersten Linse (17) des dioptrischen Objektivteils (8) liegt und vorzugsweise frei zugänglich ist. Die Anordnung des Zwischenbildes mit großem Abstand hinter der letzten Spiegelfläche (10) der Strahlumlenkeinrichtung (7) zwischen zwei Linsen (17, 21) des dioptrischen Objektivteils (8) trägt zur Vermeidung von Abbildungsfehlern bei.

Fig. 1

**Beschreibung**

Die Erfindung betrifft ein katadioptrisches Projektionsobjektiv zur Abbildung eines in einer Objektebene angeordneten Musters in eine Bildebene.

Derartige Projektionsobjektive werden in Projektionsbelichtungsanlagen zur Herstellung von Halbleiterbauelementen und anderen feinstrukturierten Bauteilen verwendet, insbesondere in Waferscannern und Wafersteppern. Sie dienen dazu, Muster von Photomasken oder Strichplatten, die nachfolgend allgemein als Masken oder Retikel bezeichnet werden, auf einen mit einer lichtempfindlichen Schicht beschichteten Gegenstand mit höchster Auflösung in verkleinerndem Maßstab zu projizieren.

Dabei ist es zur Erzeugung immer feinerer Strukturen notwendig, einerseits die bildseitige numerische Apertur (NA) des Projektionsobjektivs zu vergrößern und andererseits immer kürzere Wellenlängen zu verwenden, vorzugsweise Ultraviolett-licht mit Wellenlängen von weniger als ca. 260 nm.

In diesem Wellenlängenbereich stehen nur noch wenig ausreichend transparente Materialien zur Herstellung der optischen Komponenten zur Verfügung, insbesondere synthetisches Quarzglas und Fluoridkristalle, wie Calciumfluorid, Magnesiumfluorid, Bariumfluorid, Lithiumfluorid, Lithium-Kalzium-Aluminium-Fluorid, Lithium-Strontium-Aluminium-Fluorid o. dgl. Da die Abbékonstanten der verfügbaren Materialien relativ nahe beieinanderliegen, ist es schwierig, rein refraktive Systeme mit ausreichender Korrektur von Farbfehlern (chromatische Aberration) bereitzustellen. Dieses Problem wäre durch Nutzung rein reflektiver Systeme lösbar. Jedoch ist die Herstellung derartiger Spiegelsysteme aufwendig.

In Anbetracht der obigen Probleme werden für höchstauflösende Projektionsobjektive der genannten Art überwiegend katadioptrische Systeme verwendet, bei denen brechende und reflektierende Komponenten, insbesondere also Linsen und Spiegel, kombiniert sind.

Bei der Nutzung von abbildenden Spiegelflächen ist es erforderlich, Strahlumlenkeinrichtungen einzusetzen, wenn eine obskurationsfreie und vignettierungsfreie Abbildung erreicht werden soll. Es sind sowohl Systeme mit einem oder mehreren Umlenkspiegeln, als auch Systeme mit physikalischen Strahlteilern bekannt. Darüber hinaus können weitere Planspiegel zur Faltung des Strahlengangs verwendet werden. Diese werden im allgemeinen nur verwendet, um Bauraumanforderungen zu erfüllen, insbesondere um Objekt- und Bildebene parallel zueinander auszurichten. Diese Faltungsspiegel sind optisch nicht zwingend erforderlich.

Systeme mit einem physikalischen Strahlteiler, beispielsweise in Form eines Strahlteilerwürfels (BSC, beam splitter cube), haben den Vorteil, dass axiale (on-axis) Systeme realisierbar sind. Hier werden polarisationsselektiv wirksame Spiegelflächen eingesetzt, die abhängig von der Polarisationsvorzugsrichtung der auftreffenden Strahlung reflektierend oder transmittierend wirken. Nachteilig an solchen Systemen ist, dass geeignete transparente Materialien kaum in den erforderlich großen Volumina verfügbar sind. Außerdem kann die Herstellung der optisch wirksamen Strahlteilerschichten innerhalb der Strahlteilerwürfeln erhebliche Schwierigkeiten machen. Auch Aufheizungseffekte im Strahlteiler können problematisch sein, insbesondere dann, wenn die Strahlenbelastung im Strahlteiler groß ist, weil innerhalb des Strahlteilers ein Zwischenbild erzeugt wird.

Ein Beispiel für ein derartiges System ist in der EP-A-0 475 020 (entsprechend US-A-5,052,763) gezeigt. Hier liegt die Maske direkt auf einem Strahlteilerwürfel auf, und das Zwischenbild liegt hinter der Strahlteilerfläche im Inneren des Strahlteilerwürfels. Ein anderes Beispiel ist in der US-A-5,808,805 bzw. der zugehörigen Continution-Anmeldung US-A-5,999,333 gezeigt. Hier liegt zwischen der Objektebene und einem Strahlteilerwürfel eine mehrlinsige Linsengruppe mit positiver Brechkraft. Das gesammelte Lichtbündel wird zunächst von der Polarisationsstrahlteilerfläche in Richtung eines Konkavspiegels gelenkt und von diesem zurück in den Strahlteilerwürfel und durch die Strahlteilerfläche in Richtung der nachfolgenden Linsengruppe mit insgesamt positiver Brechkraft reflektiert. Das Zwischenbild liegt innerhalb des Strahlteilerwürfels in unmittelbarer Nähe der Strahlteilerfläche. In diesen Dokumenten sind keine Angaben über entstehende Aufheizprobleme oder deren Vermeidung gemacht.

In der EP-A-0 887 708 sind für ein katadioptrisches System mit Strahlteilerwürfel, jedoch offenbar ohne Zwischenbild im Strahlteilerwürfel, Maßnahmen zur Vermeidung von aufheizungsbedingten Abbildungsfehlern angegeben. Durch geeignete Strahlführung von durch den Strahlteilerwürfel hindurchtretenden Strahlen wird eine zur Strahlteilerfläche symmetrische Strahlungsintensitätverteilung angestrebt, wodurch eine zur Strahlteilerfläche symmetrische Aufwärmung erreicht werden soll. Es wird angegeben, dass sich hierdurch schwierig zu kompensierende Wellenfrontverzerrungen, wie sie sich bei ungleichförmiger Aufheizung ergeben, vermeidbar sind.

Diese Nachteile von Systemen mit Strahlteilerwürfel können bei Systemen mit einem oder mehreren Umlenkspiegeln in der Strahlumlenkeinrichtung teilweise vermieden werden. Diese Systeme haben allerdings den prinzipbedingten Nachteil, dass es sich zwingend um außeraxiale (off-axis) Systeme handelt.

Ein derartiges katadioptrisches Reduktionsobjektiv ist in der EP-A-0 989 434 (entsprechend US-Serial Nr. 09/364382) beschrieben. Bei diesem sind zwischen der Objektebene und der Bildebene ein katadioptrischer erster Objektivteil mit einem Konkavspiegel, eine Strahlumlenkeinrichtung, und hinter dieser ein dioptrischer zweiter Objektivteil angeordnet. Die als Spiegelprisma ausgebildete Strahlumlenkeinrichtung hat eine erste Spiegelfläche zur Umlenkung der von der Objektebene kommenden Strahlung zum Konkavspiegel und eine zweite Spiegelfläche zur Umlenkung der von diesem reflektierten Strahlung zum zweiten Objektivteils, der nur refraktive Elemente enthält. Der katadioptrische erste Objektivteil erzeugt ein reelles Zwischenbild, welches mit geringem Abstand hinter der zweiten Spiegelfläche und mit Abstand vor der ersten Linse des zweiten Objektivteiles liegt. Das Zwischenbild ist dadurch frei zugänglich, was z. B. zur Anbringung einer Leuchtfeldblende genutzt werden kann.

Ein anderes Reduktionsobjektiv, das eine Strahlumlenkeinrichtung mit einem Umlenkspiegel aufweist, ist in der US-A-5,969,882 (entsprechend EP-A-0 869 383) beschrieben. Bei diesem System ist der Umlenkspiegel so angeordnet, dass das von der Objektebene kommende Licht zunächst auf den Konkavspiegel des ersten Objektivteiles fällt, bevor es von diesem zum Umlenkspiegel der Strahlumlenkeinrichtung reflektiert wird. Von diesem wird es zu einer weiteren Spiegelfläche reflektiert, die das Licht in Richtung der Linse des rein dioptrischen zweiten Objektivteilers lenkt. Die für die Erzeugung des Zwischenbildes genutzten Elemente des ersten Objektivteils sind so ausgelegt, dass das Zwischenbild nahe bei dem Umlenkspiegel der Strahlumlenkeinrichtung liegt. Der zweite Objektivteil dient der Refokussierung des Zwischenbildes auf die Bildebene, die dank der dem Zwischenbild folgenden Spiegelfläche parallel zur Objektebene angeordnet sein kann.

Die US-A-6,157,498 zeigt einen ähnlichen Aufbau, bei dem das Zwischenbild auf oder nahe der Spiegelfläche der Strahlumlenkeinrichtung liegt. Zwischen dieser und einem Umlenkspiegel im zweiten Objektivteil sind einige Linsen des zweiten Objektivteil angeordnet. In unmittelbarer Nähe oder bei dem Zwischenbild ist auch eine asphärische Fläche angeordnet. Hierdurch soll ausschließlich Verzeichnung korrigiert werden, ohne dass andere Bildfehler beeinflusst werden.

Ein Projektionsobjektiv mit verkleinerndem katadioptrischen Teilsystem und Zwischenbild in der Nähe eines Umlenkspiegels einer Strahlumlenkeinrichtung ist in der DE 197 26 058 gezeigt.

In der schon erwähnten US-A-5,999,333 ist ein anderes katadioptrisches Reduktionsobjektiv mit Umlenkspiegel gezeigt, bei dem das von der Objektebene kommende Licht zuerst auf den Konkavspiegel trifft, von dem es auf die einzige Spiegelfläche der Umlenkeinrichtung reflektiert wird. Das vom katadioptrischen Teil erzeugte Zwischenbild liegt nahe bei dieser Spiegelfläche. Diese reflektiert das Licht zu einem dioptrischen, zweiten Objektivteil, der das Zwischenbild auf die Bildebene abbildet. Sowohl der katadioptrische Objektivteil, als auch der dioptrische Objektivteil haben einen verkleinernden Abbildungsmaßstab.

Ein ähnlicher Objektivaufbau, bei dem ebenfalls das vom katadioptrischen Objektivteil erzeugte Zwischenbild in der Nähe des einzigen Umlenkspiegels der Strahlumlenkeinrichtung liegt, ist in der JP-A-10010429 gezeigt. Die dem Umlenkspiegel nächste Linsenfläche des nachfolgenden dioptrischen Objektivteils ist asphärisch, um besonders wirksam zur Korrektur der Verzeichnung beizutragen.

Die Systeme, bei denen das Zwischenbild in der Nähe oder auf einer reflektierenden Fläche liegt, ermöglichen eine kompakte Bauweise. Zudem kann der zu korrigierende Feldradius dieser außeraxial beleuchteten Systeme klein gehalten werden. Nachteilig ist, daß schon kleinste Fehler der Spiegelfläche die Qualität der Abbildung in der Bildebene beeinträchtigen können. Zudem kann die Konzentration von Strahlungsenergie auf Spiegelflächen zu Aufheizeffekten führen, die die Qualität der Abbildung beeinträchtigen. Die lokal hohe Strahlenbelastung kann auch Schäden an den normalerweise auf Spiegelflächen vorgesehenen Reflexbeschichtungen hervorrufen.

Es ist eine Aufgabe der Erfindung, Nachteile des Standes der Technik zu vermeiden. Insbesondere soll ein Projektionsobjektiv geschaffen werden, dessen Abbildungsleistung relativ unempfindlich gegen Fertigungstoleranzen ist.

Zur Lösung dieser Aufgabe schlägt die Erfindung ein katadioptrisches Projektionsobjektiv mit den Merkmalen von Anspruch 1 vor. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Ein erfindungsgemäßes Projektionsobjektiv der eingangs erwähnten Art zeichnet sich dadurch aus, daß der hinter der letzten Spiegelfläche der Strahlumlenkeinrichtung beginnende, dioptrische zweite Objektivteil mindestens eine Linse aufweist, die zwischen dieser letzten Spiegelfläche und dem Zwischenbild angeordnet ist. Das Zwischenbild liegt also innerhalb des zweiten, rein refraktiven Objektivteiles, so daß die mindestens eine dem Zwischenbild vorgeschaltete Linse des zweiten Objektivteiles zur Erzeugung des Zwischenbildes beitragen kann. Erfindungsgemäß ist somit vorgesehen, daß zwischen der letzten Spiegelfläche der Strahlumlenkeinrichtung und dem Zwischenbild ein erheblicher Abstand liegt. Dadurch kann z. B. ein zugängliches Zwischenbild geschaffen werden, um beispielsweise eine Leuchtfeldblende zur Verminderung von Streulicht anzubringen. Besonders vorteilhaft ist es, dass dadurch die letzte Spiegelfläche im Bereich größerer Büscheldurchmesser liegt. Dadurch ist eine gleichmäßigere Ausleuchtung unter Vermeidung gefährlicher lokaler Strahlungsdichtemaxima gewährleistet, und es wird eine gegebenenfalls vorhandene Aufheizung der diese Fläche tragenden optischen Komponente vergleichmäßigt, was zur Verbesserung der Abbildungsqualität beiträgt. Vor allem aber wirken sich kleine Fehler in der Spiegelfläche nicht oder nur vernachlässigbar auf die Abbildungsqualität in der Bildebene aus. Es können also trotz geringer Anforderungen an Flächenreinheit, Homogenität und Passe der letzten Spiegelfläche Objektive hoher Abbildungsqualität gebaut werden.

Als "letzte Spiegelfläche" wird hier diejenige Spiegelfläche bezeichnet, die im Lichtweg direkt vor dem Zwischenbild liegt. Es kann sich dabei um eine polarisationsselektiv wirkende Strahlteilerfläche eines Strahlteilerblocks (BSC) handeln oder um einen voll reflektierenden Umlenkspiegel, dem gegebenenfalls ein weiterer Umlenkspiegel einer Strahlumlenkungseinrichtung vorgeschaltet sein kann. Ebenso sind Rückflächenspiegel in Form von Umlenkprismen denkbar. Die "letzte Spiegelfläche" schließt bei erfindungsgemäßen Projektionsobjektiven den katadioptrischen Objektivteil ab. Der letzten Spiegelfläche kann zu Beginn oder zwischen Linsen des zweiten Objektivteils eine weitere Spiegelfläche folgen, die eine baulich günstige Faltung des Strahlengangs bewirkt, um z. B. Objekt- und Bildebene parallel zueinander anordnen zu können.

Das hier als Linse bezeichnete optische Element zwischen letzter Spiegelfläche und Zwischenbild kann auch eine von einer herkömmlichen Linse abweichende Form und Funktion haben, z.B. die Form einer Planplatte mit asphärischer Korrektur oder die Form einer Teil-Linse oder Halblinse. Daher steht hier "Linse" allgemein für ein transparentes optisches Element mit einer optischen Wirkung auf die durchtretende Strahlung.

Diese oben genannten Vorteile ergeben sich unabhängig von der Zwischenschaltung einer Linse vor allem aus dem erheblichen Abstand zwischen der letzten Spiegelfläche und dem reellen Zwischenbild. Der Abstand, der nachfolgend auch als Zwischenbildabstand bezeichnet wird, ist vorzugsweise so bemessen, dass der Durchmesser der Strahlenbündel auf einer zur optischen Achse senkrecht stehenden Fläche im Schnittpunkt der letzten Spiegelfläche mit der optischen Achse mindestens 10% des Durchmessers des Konkavspiegels beträgt, z.B. 17% oder mehr dieses Durchmessers. Der Abstand sollte jedoch nicht so groß werden, dass das Durchmesserverhältnis deutlich über 20% oder 25% ansteigt, um die zu korrigierenden Feldradien ausreichend klein zu halten. Der große Zwischenbildabstand ermöglicht die Zwischenschaltung der mindestens einen Linse. Diese hat vorzugsweise positive Brechkraft, wodurch die Durchmesser der dem Zwischenbild nachfolgender Linsen gering gehalten werden können. Dies fördert eine materialsparende Konstruktion des zweiten Objektivteils.

Die Anordnung mindestens einer Linse zwischen letzter Spiegelfläche und Zwischenbild schafft zudem bisher unbekannte Möglichkeiten, nachteilige Effekte der Linsenaufheizung zu minimieren oder ganz zu vermeiden. Bei einer bevorzugten Ausführungsform ist hierzu vorgesehen, daß objektseitig vor dem Zwischenbild eine vordere Zwischenbildlinse und bildseitig hinter dem Zwischenbild eine hintere Zwischenbildlinse angeordnet ist und daß die Zwischenbildlinsen in Bezug auf das Zwischenbild derart symmetrisch angeordnet sind, daß sich durch Linsenaufheizung (Lens-Heating) verursachte asymmetrische Beiträge zu Bildfehlern, wie Koma, der Zwischenbildlinsen teilweise oder im wesentlichen vollständig kompensieren. Dies wird bei den Ausführungsbeispielen noch näher erläutert.

Die hier angesprochene symmetrische Anordnung von vorderer und hinterer Zwischenbildlinse zur teilweisen oder vollständigen Kompensation asymmetrischer Lens-Heating-Effekte im Bereich eines Zwischenbildes ist nicht nur bei gattungsgemäßen Projektionsobjektiven vorteilhaft, sondern auch bei anderen abbildenden optischen Systemen, bei denen mindestens ein reelles Zwischenbild erzeugt wird.

Die erfindungsgemäße günstige Anordnung des Zwischenbildes wird erleichtert, wenn der erste, katadioptrische Objektivteil nicht oder nicht wesentlich zur Gesamtverkleinerung des Projektionsobjektives beiträgt. Vorzugsweise hat der katadioptrische erste Objektivteil einen Abbildungsmaßstab $\beta_M$, der größer als ca. 0,95 ist. Bevorzugte Ausführungsformen haben einen vergrößernden Abbildungsmaßstab ($\beta_M > 1$), was eine Verschiebung des Zwischenbildes in den refraktiven zweiten Objektivteil unterstützt.

Um trotz der günstigen Anordnung des Zwischenbildes die zu korrigierenden Feldradien gering zu halten, sind vorzugsweise Korrekturmittel zur Korrektur der sphärischen Aberration des ersten Objektivteiles vorgesehen, wodurch die axialen Lagen des paraxialen Zwischenbildes und des durch Randstrahlen höherer Strahlhöhe erzeugten Randstrahl-Zwischenbildes näher zusammenrücken. Zweckmäßig ist es, wenn für die sphärische Lösungsaberration SAL des ersten Objektivteils folgende Bedingung eingehalten wird: $0<|SAL/L|<0,025$, wobei L der geometrische Abstand zwischen Objektebene und Bildebene ist. Dies wird später näher erläutert.

Bei bevorzugten Ausführungsformen ist vorgesehen, daß die dem Zwischenbild nächste Linsenfläche des refraktiven Objektivteils sphärisch ist. Es ist auch möglich, daß beide dem Zwischenbild zugewandten Linsenflächen sphärisch sind. Dadurch können ohne extreme Anforderungen bei der Linsenherstellung Objektive hoher Abbildungsleistung bei geringer Fertigungsstreuung hergestellt werden. Denn die bei der Herstellung erreichbare Formgenauigkeit (Passe) ist bei sphärischen Flächen im allgemeinen höher als bei Asphären, welche auch Oberflächen-Mikrorauhigkeit und Transmissionsgradienten aufweisen können. Andererseits wirken zwischenbildnahe Flächen besonders stark auf die Korrektur von Bildfehlern wie Verzeichnung, weshalb bei herkömmlichen Designs häufig Asphären in der Nähe von Zwischenbildern vorgesehen sind. Dagegen ist hier bevorzugt, in der Nähe des Zwischenbildes besonders gut bzw. nahezu perfekt herstellbare sphärische Linsenflächen einzusetzen.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können. Es zeigen:

Fig. 1 eine Längsschnittdarstellung einer ersten Ausführungsform der Erfindung,

Fig. 2 eine Längsschnittdarstellung einer zweiten Ausführungsform der Erfindung,

Fig. 3 eine vergrößerte Ansicht des Bereiches der Strahlumlenkeinrichtung in Fig. 1,

Fig. 4 eine Längsschnittdarstellung einer anderen Ausführungsform der Erfindung, die bezüglich der optischen Eigenschaften der Ausführungsform gemäß Fig. 1 entspricht und eine Faltung im zweiten Objektivteil aufweist, und

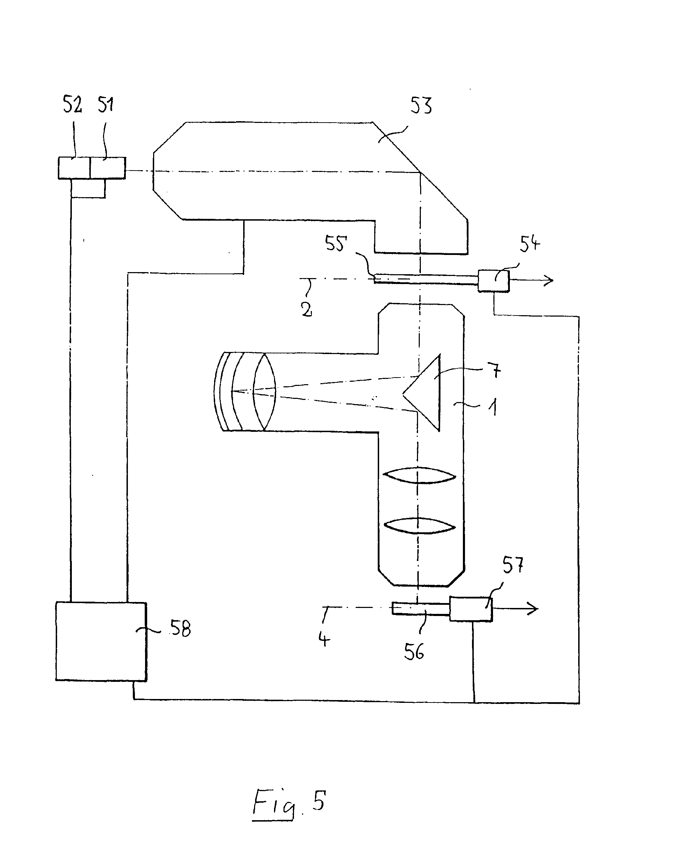

Fig. 5 eine Ausführungsform einer erfindungsgemäßen Mikrolithographie-Projektionsbelichtungsanlage.

Bei der folgenden Beschreibung bevorzugter Ausführungsformen bezeichnet der Begriff "optische Achse" eine gerade Linie oder eine Folge von geraden Linienabschnitten durch die Krümmungsmittelpunkte der optischen Komponenten. Die optische Achse wird an Umlenkspiegeln oder anderen reflektierenden Flächen gefaltet. Richtung und Abstände werden als "bildseitig" beschrieben, wenn sie in Richtung der Bildebene bzw. des dort befindlichen, zu belichtenden Substrates gerichtet sind und als "objektseitig", wenn sie in Bezug auf die optische Achse zum Objekt gerichtet sind. Das Objekt ist in den Beispielen eine Maske (Retikel) mit dem Muster einer integrierten Schaltung, es kann sich aber auch um ein anderes Muster, beispielsweise eines Gitters, handeln. Das Bild wird in den Beispielen auf einem als Substrat dienenden, mit einer Photoresistschicht versehenen Wafer gebildet, Substrate, beispielsweise Elemente für Flüssigkeitskristallanzeigen oder Substrate für optische Gitter möglich. Im folgenden werden identische oder einander entsprechende Merkmale der verschiedenen Ausführungsformen aus Gründen der Übersichtlichkeit mit den gleichen Bezugszeichen bezeichnet.

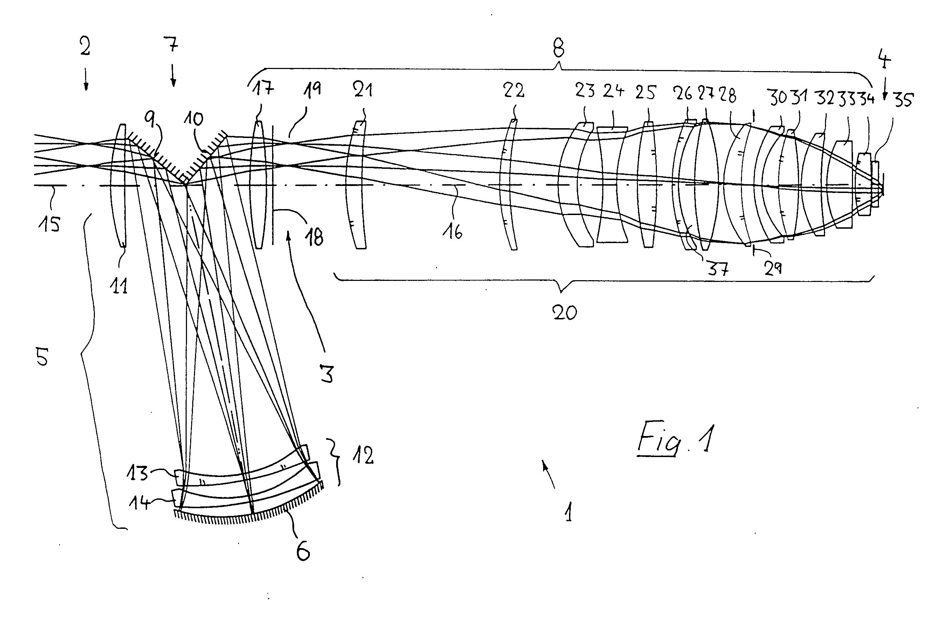

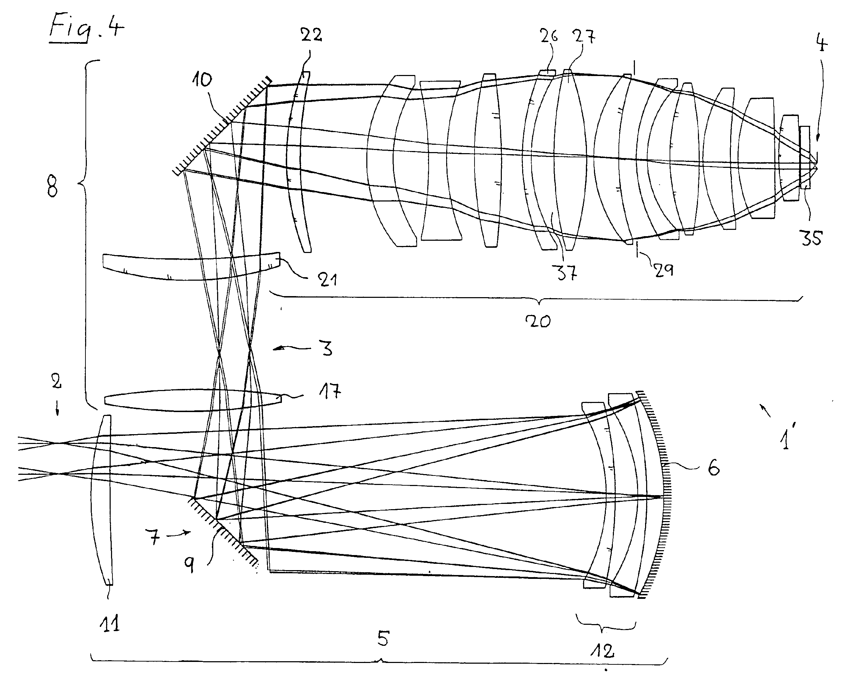

Ein typischer Aufbau eines erfindungsgemäßen katadioptrischen Reduktionsobjektivs 1 ist anhand eines ersten Ausführungsbeispiels in Figur 1 gezeigt. Es dient dazu, ein in einer Objektebene 2 angeordnetes Muster eines Retikels o. dgl. unter Erzeugung eines einzigen reellen Zwischenbildes 3 in eine Bildebene 4 in reduziertem Maßstab abzubilden, beispielsweise im Verhältnis 4:1. Das Objektiv 1 hat zwischen der Objektebene 2 und der Bildebene 3 einen katadioptrischen ersten Objektivteil 5 mit einem Konkavspiegel 6 und einer Strahlumlenkeinrichtung 7, und hinter der Strahlumlenkeinrichtung einen dioptrischen zweiten Objektivteil 8, der ausschließlich refraktive optische Komponenten enthält. Die Strahlumlenkeinrichtung 7 ist als Spiegelprisma ausgebildet und hat eine erste, ebene Spiegelfläche 9 zur Umlenkung der von der Objektebene 2 kommenden Strahlung in Richtung des Konkavspiegels, sowie eine ebene zweite Spiegelfläche 10 zur Umlenkung der vom abbildenden Konkavspiegel 6 reflektierten Strahlung in Richtung des zweiten Objektivteils 8. Die Spiegelfläche 10 bildet die letzte Spiegelfläche des katadioptrischen Teilsystems 5 und auch die letzte Spiegelfläche der Strahlumlenkeinrichtung 7. Während die erste Spiegelfläche 9 für die Strahlumlenkung zum Konkavspiegel 6 notwendig ist, kann die zweite Spiegelfläche 10 auch entfallen. Dann würden, ohne weitere Umlenkspiegel, die Objektebene und die Bildebene im wesentlichen senkrecht zueinander stehen. Wie Fig. 4 zeigt, kann eine Faltung auch innerhalb des refraktiven Objektivteils vorgegeben sein.

Wie in Figur 1 erkennbar, tritt das Licht aus einem (nicht gezeigten) Beleuchtungssystem auf der bildabgewandten Seite der Objektebene 2 in das Projektionsobjektiv ein und durchtritt dabei zunächst die in der Bildebene angeordnete Maske. Das transmittierte Licht durchtritt dann eine zwischen der Objektebene 2 und der Strahlumlenkeinrichtung 7 angeordnete Sammellinse 11 mit konvexer Eintrittsfläche und wird dann von dem Faltungsspiegel 9 des Strahlteilers 7 in Richtung einer Spiegelgruppe 12 umgelenkt, die den Konkavspiegel 6 sowie zwei diesem unmittelbar vorangestellte Negativlinsen 13, 14 umfaßt, deren Flächen jeweils zum Spiegel 6 gekrümmt sind. Der Faltungsspiegel 9 ist dabei derart in einem von 45° abweichenden Winkel zur optischen Achse 15 des vorausgehenden Objektivteiles ausgerichtet, daß die Umlenkung in einem Umlenkwinkel von mehr als 90°, im Beispiel ca. 100°, erfolgt. Das vom Konkavspiegel 6 reflektierte und durch die zweifach durchlaufenen Negativlinsen 13, 14 zur Strahlumlenkeinrichtung 7 zurückgeführte Licht wird vom zweiten Faltungsspiegel 10 der Strahlumlenkeinrichtung 7 in Richtung des dioptrischen zweiten Objektivteils 8 umgelenkt. Dessen optische Achse 16 verläuft parallel zur optischen Achse 15 des Eingangsteils und erlaubt somit eine parallele Anordnung zwischen Objektebene 2 und Bildebene 4, was einen einfachen Scannerbetrieb ermöglicht.

Der zweite Objektivteil 8 hat als eine Besonderheit eine dem zweiten Faltungsspiegel 10 mit Abstand nachfolgende erste Linse 17, die im Beispiel als bikonkave Positivlinse gestaltet ist und mit positiver Brechkraft zur Erzeugung des reellen Zwischenbildes 3 beiträgt. Bei der gezeigten Ausführungsform liegt das Zwischenbild mit Abstand bildseitig hinter dieser ersten Linse 17, wobei das durch eine Pseudoebene 18 gekennzeichnete paraxiale Zwischenbild näher bei der sphärischen Austrittsfläche der ersten Linse 17 liegt als das durch Randstrahlen höherer Strahlhöhe erzeugte Randstrahl-Zwischenbild 19.

Die dem Zwischenbild 3 nachfolgende hintere Linsegruppe 20 des zweiten Objektivteils 8 dient dazu, das Zwischenbild 3 in die Bildebene 4 abzubilden. Die dem Zwischenbild 3 nächste Linse 21 dieser abbildenden Linsengruppe 20 ist als Positiv-Meniskuslinse mit objektwärts gekrümmten Flächen ausgebildet und hat zum Zwischenbild 3 einen Abstand, der größer als der Abstand zwischen Zwischenbild und der ersten Linse 17 des zweiten Objektivteils 8 ist. Sie wird mit großem Abstand gefolgt von einer weiteren, objektwärts gekrümmten Positiv-Meniskuslinse 22, auf die mit axialem Abstand eine objektwärts gekrümmte Meniskuslinse 23, eine bikonkave Negativlinse 24 und eine bikonvexe Positivlinse 25 folgen. Dieser folgt eine objektwärts gekrümmte Meniskuslinse 26 mit leicht negativer Brechkraft, der eine bikonvexe Positivlinse 27 folgt. Zwischen den Linsen 26 und 27 befindet sich ein objektwärts gekrümmter, meniskusförmiger Luftraum 37. Unmittelbar hinter der nachfolgenden, objektwärts gekrümmten Meniskuslinse 28 positiver Brechkraft liegt die frei zugängliche Systemblende 29, so dass der Luftraum 37 in der Nähe der Blende 29 vor dieser angeordnet ist. Eine der Blende 29 nachfolgende Negativ-Meniskuslinse 30 mit bildseitiger Konkavfläche, eine darauffolgende bikonvexe Positivlinse 31, eine objektwärts gekrümmte Meniskuslinse 32 positiver Brechkraft, eine darauffolgende, dicke bikonvexe Positivlinse 33 und eine weitere bikonvexe Positivlinse 34 kleineren Durchmessers dienen der Zusammenführung des Strahls in Richtung Waferebene 4. Als wafernächste optische Komponente ist eine planparallele Abschlußplatte 35 vorgesehen.

In Tabelle 1 ist die Spezifikation des Design in tabellarischer Form zusammengefaßt. Dabei gibt Spalte 1 die Nummer der brechenden, reflektierenden oder auf andere Weise ausgezeichneten Fläche F, Spalte 2 den Radius r der Fläche (in mm), Spalte 3 den als Dicke bezeichneten Abstand d der Fläche zur nachfolgenden Fläche (in mm), Spalte 4 den als Index bezeichneten Brechungsindex des Materials des Bauelementes, das der Eintrittsfläche folgt, an. In Spalte 5 sind die reflektierenden Flächen gekennzeichnet. Die Gesamtlänge L des Objektivs zwischen Objekt- und Bildebene beträgt ca. 1250 mm.

Bei der Ausführungsform sind acht der Flächen, nämlich die Flächen F7 bzw. F13, F20, F22, F29, F30, F36, F39 und F45 asphärisch. Die Asphären sind in der Zeichnungsfigur durch Doppelstriche gekennzeichnet. Tabelle 2 gibt die entsprechenden Asphärendaten an, wobei die asphärischen Flächen nach folgender Vorschrift berechnen:

$$p(h)=[((1/r)h^2)/(1+SQRT(1-(1+K)(1/r)^2h^2)]+C1*h^4+C^2*h^6+....$$

Dabei gibt der Kehrwert (1/r) des Radius die Flächenkrümmung und h den Abstand eines Flächenpunktes von der optischen Achse an. Somit gibt p(h) diese Pfeilhöhe, d. h. den Abstand des Flächenpunktes vom Flächenscheitel in z-Richtung, d. h. in Richtung der optischen Achse. Die Konstanten K, C1, C2 ... sind in Tabelle 2 wiedergegeben.

Das mit Hilfe dieser Angaben reproduzierbare optische System 1 ist für eine Arbeitswellenlänge von ca. 157 nm ausgelegt, bei der das für alle Linsen verwendete Linsenmaterial Kalziumfluorid einen Brechungsindex n = 1,55841 hat. Die bildseitige numerische Apertur NA beträgt 0,80. Das System ist für ein Feld der Größe 22 x 7 mm$^2$ ausgelegt. Das System ist doppelt telezentrisch.

Im folgenden werden die Funktion des optischen Systems und einige vorteilhafte Besonderheiten näher erläutert. Die schwach positive erste Linse 11 des katadioptrischen Teils 5 hat eine Brennweite, die etwa ihrem Abstand zum Konkavspiegel 6 entspricht. Dadurch liegt der Konkavspiegel im Bereich einer Pupille des Systems und kann einen relativ kleinen Durchmesser haben, was die Fertigung des Spiegels erleichtert. Die Faltung des Strahlengangs am ersten Umlenkspiegel 9 um mehr als 90° ist günstig für einen großen Arbeitsabstand über die gesamte Breite des Objektivs.

Die beiden negativen Meniskuslinsen 13, 14 unmittelbar vor dem Konkavspiegel 6 sorgen für die Korrektur der chromatischen Längsaberration CHL. Es ist bei dieser Ausführungsform günstig, daß im zweifach durchlaufenden Teil des katadioptrischen Teilsystems 5 nur zwei Linsen 13, 14 angeordnet sind, da in diesem Bereich jede Linse z. B. im Hinblick auf Transmission und Einfluß auf die Wellenfrontqualität doppelt zählt, ohne zusätzliche Freiheitsgrade für Korrekturen zu geben.

Besonders bemerkenswert ist, daß der katadioptrische Objektivteil 5, dessen letzte wirksame Fläche der Umlenkspiegel 10 ist, nicht oder nur in geringem Ausmaß zur Gesamtverkleinerung des Systems beiträgt. Der katadioptrische Objektivteil hat bei der gezeigten Ausführungsform einen Abbildungsmaßstab |β$_M$|=0,99. Dies trägt entscheidend dazu bei, daß das Zwischenbild 3 mit großem Abstand (Zwischenbildabstand) hinter der letzten Spiegelfläche 10 des katadioptrischen Teils 5 entsteht. Damit zusammenhängend ergibt sich als weiterer Vorteil, daß die Strahlungsenergie auf dem zweiten Umlenkspiegel 10 über eine im Vergleich zum Stand der Technik größere Fläche relativ gleichmäßig verteilt ist, so daß Fehler aufgrund von ungleichmäßiger Aufheizung im Bereich des Spiegels 10 bzw. des Strahlteilers 7 reduziert oder vermieden werden. Der Zwischenbildabstand ist hier so bemessen, dass der Durchmesser der Strahlenbündel auf einer zur optischen Achse 16 senkrecht stehenden Fläche durch den Schnittpunkt der zweiten Spiegelfläche 10 mit der optischen Achse zwischen ca. 17% und ca. 18% des Durchmessers des konkaven Hauptspiegels 6 liegt.

Da das Zwischenbild nicht auf oder in unmittelbarer Nähe des Umlenkspiegels 10 liegt, können kleine herstellungsbedingte Fehler der Spiegelfläche 10 ohne weiteres toleriert werden, da diese nicht oder nur unscharf in die Bildebene 4 abgebildet werden und dementsprechend die Bilderzeugung am Wafer 4 nicht stören. Da die letzte Spiegelfläche 10 einerseits einer relativ gleichmäßigen Strahlenbelastung ausgesetzt ist und andererseits kleinere Spiegelfehler tolerierbar sind, ist zu erwarten, daß die Abbildungsqualität des Objektivs auch nach jahrelangem Dauerbetrieb nicht durch Degradationen der (beschichteten) Spiegelfläche 10 beeinträchtigt wird.

Der axiale Abstand zwischen der letzten reflektierenden Fläche 10 des katadioptrischen Teils 5 und dem dahinterliegenden Zwischenbild 3 ist bei der gezeigten Ausführungsform, wie bei allen Ausführungsformen der Erfindung, so groß, daß mindestens eine Linse des nachfolgenden dioptrischen Teilsystems 8 zwischen der letzten Spiegelfläche 10 und dem Zwischenbild 3 angeordnet werden kann. Im Ausführungsbeispiel ist dies die bikonvexe Positivlinse 17, die mit ihrer positiven Brechkraft zur Erzeugung des Zwischenbildes 3 beiträgt. Durch ausreichend große positive Brechkraft im Bereich zwischen Spiegel 10 und Zwischenbild können die Linsendurchmesser der dem Zwischenbild 3 folgenden Linsen klein gehalten werden. Dadurch wird ein materialsparender Aufbau des dioptrischen Objektivteils gefördert. Eine Materialersparnis ergibt sich auch, wenn die erste Linse 17 nur als Halblinse ausgebildet ist, was hier möglich ist, da nur etwa eine Hälfte der Linse 17 optisch genutzt wird.

Die Erfindung ermöglicht es, mit mindestens einem Zwischenbild arbeitende, katadioptrische Projektionsobjektive im Hinblick auf negative Auswirkungen von asymmetrischer Linsenaufheizung zu optimieren, indem die das Zwischenbild umgebenden Linsen 17, 21 in besonderer Weise zur Vermeidung von Lens-Heating-Effekten aneinander angepaßt sind. Die objektseitig vor dem Zwischenbild 3 liegende erste Linse 17 wird auch als vordere Zwischenbildlinse und die dem Zwischenbild nachfolgende Meniskuslinse 21 als hintere Zwischenbildlinse bezeichnet. Die Zwischenbildlinsen 17, 21 sind in Bezug auf das Zwischenbild 3 derart symmetrisch angeordnet, daß sich durch Linsenaufheizung verursachte Beiträge der Zwischenbildlinsen zu Bildfehlern, wie Koma, teilweise oder im wesentlichen vollständig kompensieren. Dabei kann die erste Zwischenbildlinse 17 sozusagen einen Vorhalt an aufheizungsbedingten Bildfehlern bereitstellen, der durch die nachgeschaltete, ebenfalls sich aufheizende hintere Zwischenbildlinse 21 kompensiert wird. Bei den beispielhaft beschriebenen außer-axialen Systemen werden Linsen im Bereich des Zwischenbildes 3 extrem asymmetrisch beleuchtet. Dies führt bei Linsen im Zwischenbildbereich zu stark asymmetrischen Effekten der Linsenaufheizung. Diese Effekte sind maßgeblich für nicht-korrigierbare Verzeichnung und Koma der Abbildung am Wafer verantwortlich. Hier ist zu beachten, daß die durch Linsenaufheizung verursachten Bildfehler insbesondere bei den hier beispielhaft erläuterten katadioptrischen Systemen begrenzend für die Abbildungsqualität sein können.

Ordnet man nun die Linsen 17, 21 in der beschriebenen Weise symmetrisch um das Zwischenbild 3 herum an, so kann beispielsweise erreicht werden, daß die oberen und unteren Randstrahlen der Feldbündel an der vorderen und der hinteren Zwischenbildlinse 17 bzw. 21 gerade ihre Höhenverhältnisse, d.h. ihren Abstand zur optischen Achse 16 wechseln. So kann erreicht werden, daß asymmetrische Linsenaufheizungseffekte der vorderen Zwischenbildlinse 17 durch die hintere Zwischenbildlinse 21 teilweise oder vollständig ausgeglichen werden.

Die hier angesprochene Symmetrie in Bezug auf den Ausgleich unsymmetrischer Linsenaufheizungseffekte ist i.d.R. nicht gleichbedeutend mit einer geometrischen Symmetrie, beispielsweise einer Spiegelsymmetrie in Bezug auf die Lage des Zwischenbildes 3. Dies wird anhand der Ausführungsform gem. Fig. 1 deutlich, bei der das Zwischenbild näher bei der sphärischen Austrittsfläche der ersten Zwischenbildlinse 17 liegt, als bei der asphärischen Eintrittsfläche der hinteren Zwischenbildlinse 21.

Von den Linsen 17 bis 35 des zweiten Objektivteils 8 tragen nur diejenigen der hinteren Linsengruppe 20, also nicht die Eingangslinse 17, zur Abbildung des Zwischenbildes in die Waferebene 4 bei. Sie sind in geeigneter Weise kombiniert, um Bildfehler des Zwischenbildes so weit zu korrigieren, daß am Wafer 4 ein ausreichender Korrekturzustand erreicht wird. Unter den Linsen der zweiten Linsengruppe 20 nimmt die zwischenbildnächste Linse 21 eine Sonderrolle ein, da durch diese Linse verursachte Bildfehler aufgrund asymmetrischer Linsenaufheizung durch die dem Zwischenbild vorgeschaltete Linse 17 mindestens teilweise kompensiert werden. Diese schafft einen Vorhalt an aufheizungsbedingter Verzeichnung, der beim Lichtdurchtritt durch die Linse 21 abgebaut wird.

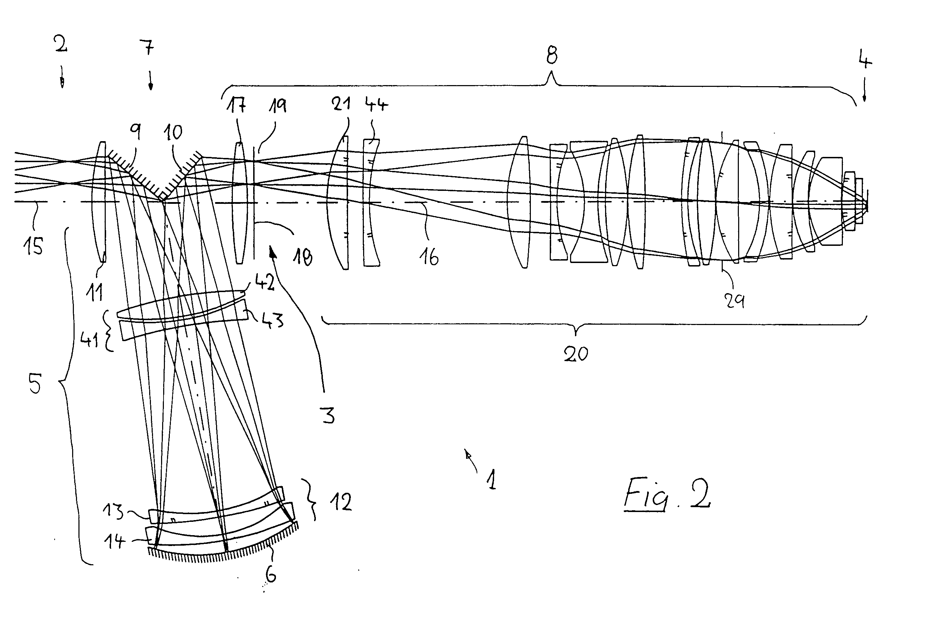

In Fig. 2 ist der Linsenschnitt einer anderen Ausführungsform gezeigt, deren Spezifikation im Detail aus Tabelle 3 und Tabelle 4 (Asphärendaten) entnehmbar ist. Das ebenfalls für eine Arbeitswellenlänge von ca. 157 nm ausgelegte Reduktionsobjektiv 1 ist im Grundaufbau der Ausführungsform gemäß Fig. 1 ähnlich und hat ebenfalls eine numerische Apertur NA=0,80. Für entsprechende Linsen bzw. Linsengruppen sind die gleichen Bezugszeichen wie in Fig. 1 verwendet. Ein wesentlicher Unterschied zu diesem Design liegt darin, daß im doppelt durchlaufenen Weg etwa im Mittelbereich zwischen Strahlteiler 7 und Spiegelgruppe 12 eine Zwischenlinsengruppe 41 angeordnet ist, die aus einer dem Strahlteiler 7 zugewandten, bikonvexen Positivlinse 42 und einer der Spiegelgruppe 12 zugewandten, bikonkaven Negativlinse 42 besteht. Eine Erhöhung der Brechkraft der Zwischenlinsengruppe 41 kann sich vorteilhaft auf den Durchmesser der Spiegelgruppe 12 auswirken, der dann geringer sein kann. Im zwischenbildnahen Bereich ist zusätzlich zur hinteren Zwischenbildlinse 21 eine Negativlinse 44 vorgesehen.

Im Unterschied zur Ausführungsform gemäß Fig. 1 ist nicht nur die dem Zwischenbild 3 zugewandte Austrittsfläche der ersten Zwischenbildlinse 17, sondern auch die dem Zwischenbild zugewandte, objektwärts konvexe Eintrittsfläche der hinteren Zwischenbildlinse 21 sphärisch. Damit sind beide zwischenbildnahen Linsenflächen mit hoher Formgenauigkeit (Passe) herstellbar, wodurch herstellungsbedingte Bildfehler, die z.B. durch Flächengradienten oder Mikrorauhigkeit verursacht werden können, minimiert werden.

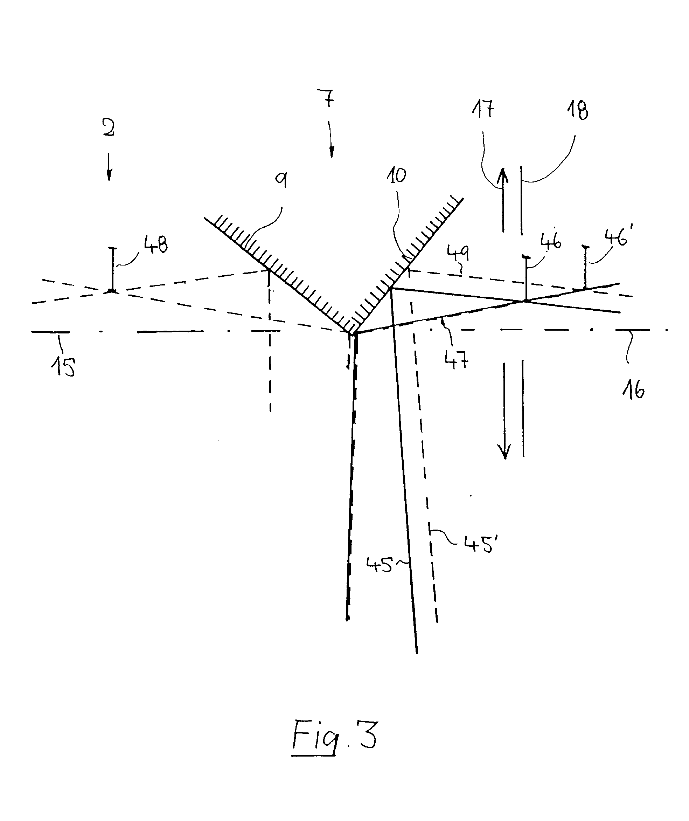

Bei erfindungsgemäßen Objektiven sind kleine sphärische Längsaberrationen SAL am Zwischenbild vorteilhaft. Bei den hier typischen Gesamtlängen L von ca. 1250 mm sollte SAL nicht mehr als ca. 30 mm oder maximal 20 mm betragen, so dass der Betrag des Verhältnisses SAL/L einen Wert von ca. 0,025 nicht wesentlich übersteigen sollte. Unter diesen Bedingungen können die zu korrigierenden Feldradien trotz großen Zwischenbildabstandes gering gehalten werden. Dies wird anhand Fig. 3 näher erläutert. Diese zeigt schematisch den Bereich des Strahlteilerprismas 7 aus Fig. 1, wobei die vordere Zwischenbildlinse 17 nur schematisch gezeigt ist. Mit durchgezogener Linie ist ein vom Konkavspiegel kommendes, achsnahes Strahlbündel 45 gezeigt, das in der Ebene 18 des paraxialen Zwischenbildes ein Randstrahl-Zwischenbild 46 bei geringer sphärischer Längsaberration bildet. Das Strahlbündel ist so geführt, dass sein der optischen Achse 16 zugewandter Rand 47 gerade noch vollständig auf die zweite Strahlteilerfläche 10 fällt, so dass eine vignettierungsfreie Abbildung entsteht. Bei größeren sphärischen Aberrationen ist eine vignettierungsfreie Abbildung unter sonst gleichen Bedingungen nur dann zu erreichen, wenn das Objektfeld 48, und damit das zugehörige Zwischenbild 46', seinen Abstand zur optischen Achse 16 vergrößert. Dies wird anhand des gestrichelt gezeigten Strahlenbündels 45' erkennbar, dessen Randstrahl-Zwischenbild 46' mit Abstand hinter der Ebene 18 des paraxialen Zwischenbildes entsteht. Im Vergleich zum Strahlbündel 45 bleibt die Lage des achsnahen Randstrahles 47 praktisch unverändert, während sich die Position des achsfernen Randstranhls 49 bei unverändertem Strahlbündelöffnungswinkel von der von der optischen Achse 16 wegbewegt hat. Es ist zu erkennen, dass der Abstand zwischen Zwischenbild 46 und optischer Achse 16 geringer wird, je geringer die sphärische Längsaberration (Abstand zwischen paraxialem Zwischenbild 18 und Randstrahl-Zwischenbild) wird. Entsprechendes gilt auch für die Lage des Objektfeldes. Daher sind geringe sphärische Aberrationen günstig, um die zu korrigierenden Feldradien gering zu halten.

Im Rahmen der Erfindung sind zahlreiche Varianten möglich, die nicht bildlich dargestellt sind. Beispielsweise können die Faltungsspiegel 9, 10 der Strahlumlenkeinrichtung 7 durch voneinander getrennte Faltungsspiegel, gegebenenfalls mit anderer Orientierung ersetzt werden. Bei Objektiven geringerer numerischer Apertur und/oder bei Objektiven mit einem im wesentlichen rechtwinklig abstehenden Seitenarm für den Hauptspiegel 6 können anstatt reflexbeschichteter Spiegelflächen auch totalreflektierende Spiegelflächen benutzt werden, beispielsweise in einem Umlenkprisma. Es ist auch möglich, die mit zwei voll reflektierenden Umlenkspiegeln 9, 10 ausgestaltete Strahlumlenkeinrichtung 7 durch einen physikalischen Strahlteiler zu ersetzen, beispielsweise durch einen Strahlteilerblock mit einer einzigen Strahlteilerfläche, die teils in Reflexion und teils in Transmission genutzt wird. Es kann sich dabei um einen teildurchlässigen Spiegel handeln, bevorzugt ist jedoch ein Polarisationsstrahlteiler. Diese Fläche bildet dann die letzte Spiegelfläche vor dem Zwischenbild.

Eine weitere Möglichkeit, ein erfindungsgemäßes Projektionsobjektiv aufzubauen, ist in Fig. 4 gezeigt. Das dortige Projektionsobjektiv 1 entspricht in seinem optisch maßgeblichen Aufbau (z. B. Linsenart- und zahl, Krümmungsradien, Luftabstände etc.) genau der Ausführungsform gem. Fig. 1 (Tabellen 1 und 2). Jedoch umfasst die konstruktiv notwendige Strahlumlenkungseinrichtung 7 hier nur einen ebenen Umlenkspiegel 9. Um auch bei dieser Ausführungsform eine Parallelanordnung von Retikelebene 2 und Waferebene 4 zu ermöglichen, ist hier ein zweiter Umlenkspiegel 10 in Lichtlaufrichtung hinter dem Zwischenbild 3 innerhalb des zweiten, dioptrischen Objektivteils 8 zwischen den mit relativ großem Abstand zueinander angeordneten Linsen 21 und 22 vorgesehen. Da dieser Umlenkspiegel 10 hinter dem Zwischenbild 3 angeordnet ist, gehört er nicht zur Strahlumlenkeinrichtung 7, deren letzte Spiegelfläche nun durch den Umlenkspiegel 9 gebildet wird. Bei dieser Konstruktion trifft das von der Objektebene 2 kommende Licht zunächst auf den abbildenden Konkavspiegel 6, von dem es zum einzigen Umlenkspiegel 9 der Strahlumlenkeinrichtung 7 reflektiert wird. Die konvergent auf die letzte Spiegelfläche 9 treffende Strahlung wird von dieser zum dioptrischen zweiten Objektivteil 8 reflektiert, der aufgrund der integrierten Strahlumlenkung durch Spiegel 10 eine rechtwinklig geknickte Form aufweist. Zwischen dem Umlenkspiegel 9 und dem mit großem Abstand nachfolgenden Zwischenbild 3 ist, genau wie bei den anderen Ausführungsformen, eine Linse 17 des zweiten Objektivteils angeordnet. Alle im Zusammenhang mit Fig. 1 genannten Vorteile bleiben bei dieser Ausführungsform erhalten.

Bei den beschriebenen Ausführungsformen bestehen alle transparenten, optischen Komponenten aus dem gleichen Material, nämlich Calciumfluorid. Es können gegebenenfalls auch andere, bei der Arbeitswellenlänge transparente Materialien verwendet werden, insbesondere die eingangs erwähnten Fluoridkristallmaterialien. Gegebenenfalls kann auch mindestens ein zweites Material eingesetzt werden, um beispielsweise die chromatische Korrektur zu unterstützen. Die Vorteile der Erfindung können selbstverständlich auch bei Systemen für andere Arbeitswellenlängen des Ultraviolettbereichs verwendet werden, beispielsweise für 248 nm oder 193 nm. Da bei den gezeigten Ausführungsformen nur ein Linsenmaterial verwendet wird, ist eine Anpassung der gezeigten Designs auf andere Wellenlängen dem Fachmann besonders einfach möglich. Insbesondere bei Systemen für größere Wellenlängen können auch andere Linsenmaterialien, beispielsweise synthetisches Quarzglas für alle oder einige optische Komponenten verwendet werden.

Erfindungsgemäße Projektionsobjektive können in allen geeigneten mikrolithographischen Projektionsbelichtungsanlagen eingesetzt werden, beispielsweise in einem Waferstepper oder einem Waferscanner. In Fig. 4 ist beispielhaft ein Waferscanner 50 schematisch gezeigt. Er umfasst eine Laserlichtquelle 51 mit einer zugeordneten Einrichtung 52 zur Einengung der Bandbreite des Lasers. Ein Beleuchtungssystem 53 erzeugt ein großes, scharf begrenztes und sehr homogen beleuchtetes Bildfeld, das an die Telezentrieerfordernisse des nachgeschalteten Projektionsobjektives 1 angepaßt ist. Das Beleuchtungssystem 53 hat Einrichtungen zur Auswahl des Beleuchtungsmodus und ist beispielsweise zwischen konventioneller Beleuchtung mit variablem Kohärenzgrad, Ringfeldbeleuchtung und Dipol- oder Quadrupolbeleuchtung umschaltbar. Hinter dem Beleuchtungssystem ist eine Einrichtung 54 zum Halten und Manipulieren einer Maske 55 so angeordnet, daß die Maske 55 in der Bildebene 2 des Projektionsobjektivs 1 liegt und in dieser Ebene zum Scanbetrieb bewegbar ist. Entsprechend umfaßt die Einrichtung 54 im Fall des gezeigten Waferscanners den Scanantrieb.

Hinter der Maskenebene 2 folgt das Reduktionsobjektiv 1, das ein Bild der Maske in reduziertem Maßstab auf einem mit einer Photoresistschicht belegten Wafer 56 abbildet, der in der Bildebene 4 des Reduktionsobjektivs 1 angeordnet ist. Der Wafer 56 wird durch eine Einrichtung 57 gehalten, die einen Scannerantrieb umfaßt, um den Wafer synchron mit dem Retikel zu bewegen. Alle Systeme werden von einer Steuereinheit 58 gesteuert. Der Aufbau solcher Systeme sowie deren Arbeitsweise ist an sich bekannt und wird daher nicht mehr erläutert.

Tabelle 1

| Fläche | Radius | Dicke | Index | Refl. |
|---|---|---|---|---|
| 0 | 0,0000 | 36,000 | 1 | |
| 1 | 0,0000 | 0,000 | 1 | |
| 2 | 303,9247 | 22,169 | 1,55841 | |
| 3 | 2732,7256 | 96,271 | 1 | |
| 4 | 0,0000 | 0,000 | -1 | REFL |
| 5 | 0,0000 | -468,173 | -1 | |
| 6 | 199,7080 | -10,268 | -1,55841 | |
| 7 | 485,9116 | -25,206 | -1 | |
| 8 | 186,8130 | -10,064 | -1,55841 | |
| 9 | 448,8758 | -19,609 | -1 | |
| 10 | 243,7460 | 19,609 | 1 | REFL |
| 11 | 448,8758 | 10,064 | 1,55841 | |
| 12 | 186,8130 | 25,206 | 1 | |
| 13 | 485,9116 | 10,268 | 1,55841 | |
| 14 | 199,7080 | 469,450 | 1 | |
| 15 | 0,0000 | 0,000 | -1 | REFL |
| 16 | 0,0000 | -100,166 | -1 | |
| 17 | -532,8260 | -25,379 | -1,55841 | |
| 18 | 635,9179 | -10,000 | -1 | |
| 19 | 0,0000 | -115,933 | -1 | |
| 20 | -311,6936 | -24,721 | -1,55841 | |
| 21 | -729,4902 | -219,394 | -1 | |
| 22 | -276,2460 | -15,427 | -1,55841 | |
| 23 | -448,8506 | -75,934 | -1 | |
| 24 | -158,3810 | -30,587 | -1,55841 | |
| 25 | -163,4782 | -40,576 | -1 | |
| 26 | 419,7809 | -20,540 | -1,55841 | |
| 27 | -237,0092 | -32,234 | -1 | |
| 28 | -428,0516 | -30,182 | -1,55841 | |
| 29 | 693,3900 | -23,874 | -1 | |
| 30 | -241,2068 | -10,000 | -1,55841 | |
| 31 | -182,4638 | -25,712 | -1 | |
| 32 | -422,9386 | -36,706 | -1,55841 | |
| 33 | 327,0334 | -7,823 | -1 | |
| 34 | -150,5655 | -28,311 | -1,55841 | |
| 35 | -314,2186 | -15,947 | -1 | |
| 36 | 0,0000 | -3,484 | -1 | |
| 37 | -172,8501 | -12,272 | -1,55841 | |
| 38 | -116,0764 | -25,993 | -1 | |
| 39 | -230,6308 | -32,436 | -1,55841 | |

Tabelle 1   (fortgesetzt)

| Fläche | Radius | Dicke | Index | Refl. |
|---|---|---|---|---|
| 40 | 465,5346 | -4,280 | -1 | |
| 41 | -153,0332 | -30,802 | -1,55841 | |
| 42 | -514,5406 | -8,487 | -1 | |
| 43 | -157,6109 | -41,061 | -1,55841 | |
| 44 | 2904,8207 | -4,477 | -1 | |
| 45 | -226,8988 | -24,123 | -1,55841 | |
| 46 | 847,7062 | -0,972 | -1 | |
| 47 | 0,0000 | -10,000 | -1,55841 | |
| 48 | 0,0000 | -8,006 | -1 | |
| 49 | 0,0000 | 0,000 | -1 | |

Tabelle 2

| Fläche | K | C1 | C2 | C3 | C4 | C5 | C6 |
|---|---|---|---|---|---|---|---|
| 7 | 0 | 3,8786E-09 | -1,5770E-13 | 1,6270E-17 | -1,1233E-21 | -1,5136E-26 | 8,5713E-31 |
| 13 | 0 | 3,8786E-09 | -1,5770E-13 | 1,6270E-17 | -1,1233E-21 | -1,5136E-26 | 8,5713E-31 |
| 20 | 0 | 3,6292E-09 | 6,7560E-14 | 5,6841E-19 | -6,7883E-23 | 6,7834E-27 | -2,0530E-31 |
| 22 | 0 | 1,1976E-08 | 7,3544E-14 | 7,0329E-19 | -1,2632E-23 | -3,0105E-27 | 2,0874E-31 |
| 29 | 0 | -8,3929E-09 | -3,3961E-13 | 8,7632E-18 | -1,4358E-21 | 5,5923E-26 | 2,0181E-30 |
| 30 | 0 | 1,7409E-08 | -1,6961E-13 | 1,1828E-17 | -3,0819E-21 | 1,7008E-25 | -1,6848E-30 |
| 35 | 0 | -2,1445E-08 | 6,7395E-13 | -4,8468E-17 | 5,9926E-21 | -2,8763E-25 | 3,9059E-31 |
| 39 | 0 | 1,6042E-08 | 4,7884E-15 | 2,0832E-16 | -2,8771E-20 | 1,7749E-24 | -1,9350E-29 |
| 45 | 0 | -6,5639E-08 | -8,2521E-12 | -1,2733E-16 | -1,1662E-20 | -1,5813E-23 | 6,3953E-27 |

Tabelle 3

| Fläche | Radius | Dicke | Index | Refl. |
|---|---|---|---|---|
| 0 | 0,0000 | 36,0000 | 1,000000 | |
| 1 | 0,0000 | 0,0000 | 1,000000 | |
| 2 | 333,2125 | 20,7650 | 1,558410 | |
| 3 | 3917,6389 | 94,1110 | 1,000000 | |
| 4 | 0,0000 | 0,0000 | -1,000000 | REFL |
| 5 | 0,0000 | -148,1340 | -1,000000 | |
| 6 | -595,2534 | -32,1340 | -1,558410 | |
| 7 | 331,1147 | -5,4880 | -1,000000 | |
| 8 | 312,7988 | -10,0000 | -1,558410 | |
| 9 | -682,8537 | -300,0000 | -1,000000 | |
| 10 | 264,3436 | -10,2440 | -1,558410 | |
| 11 | 731,0776 | -28,2930 | -1,000000 | |
| 12 | 191,6338 | -10,0480 | -1,558410 | |
| 13 | 479,5908 | -19,2310 | -1,000000 | |
| 14 | 254,9692 | 19,2310 | 1,000000 | REFL |
| 15 | 479,5908 | 10,0480 | 1,558410 | |
| 16 | 191,6338 | 28,2930 | 1,000000 | |
| 17 | 731,0776 | 10,2440 | 1,558410 | |
| 18 | 264,3436 | 300,0000 | 1,000000 | |
| 19 | -682,8537 | 10,0000 | 1,558410 | |
| 20 | 312,7988 | 5,4880 | 1,000000 | |
| 21 | 331,1147 | 32,1340 | 1,558410 | |

Tabelle 3 (fortgesetzt)

| Fläche | Radius | Dicke | Index | Refl. |
|---|---|---|---|---|
| 22 | -595,2534 | 146,3160 | 1,000000 | |
| 23 | 0,0000 | 0,0000 | -1,000000 | REFL |
| 24 | 0,0000 | -112,8570 | -1,000000 | |
| 25 | -660,9668 | -23,0610 | -1,558410 | |
| 26 | 556,1870 | -10,0000 | -1,000000 | |
| 27 | 0,0000 | -116,4030 | -1,000000 | |
| 28 | -226,5082 | -31,7500 | -1,558410 | |
| 29 | -3414,2334 | -25,1180 | -1,000000 | |
| 30 | -3354,8183 | -10,0000 | -1,558410 | |
| 31 | -314,6991 | -217,5910 | -1,000000 | |
| 32 | -233,5958 | -36,8330 | -1,558410 | |
| 33 | 960,2043 | -32,3470 | -1,000000 | |
| 34 | 5805,6084 | -10,0020 | -1,558410 | |
| 35 | -240,7709 | -42,3390 | -1,000000 | |
| 36 | 169,2097 | -20,9060 | -1,558410 | |
| 37 | -286,7201 | -11,5480 | -1,000000 | |
| 38 | -478,5727 | -34,5630 | -1,558410 | |
| 39 | 301,8036 | -1,0000 | -1,000000 | |
| 40 | -355,1135 | -27,7490 | -1,558410 | |
| 41 | 1378,0763 | -56,2110 | -1,000000 | |
| 42 | -415,3177 | -10,0000 | -1,558410 | |
| 43 | -256,9507 | -15,2090 | -1,000000 | |
| 44 | -559,7690 | -26,8590 | -1,558410 | |
| 45 | 479,6752 | -10,5000 | -1,000000 | |
| 46 | 0,0000 | 9,4930 | -1,000000 | |
| 47 | -174,1879 | -35,5680 | -1,558410 | |
| 48 | -7171,0639 | -32,6510 | -1,000000 | |
| 49 | 183,6755 | -13,5520 | -1,558410 | |
| 50 | 255,5654 | -2,3140 | -1,000000 | |
| 51 | -242,4305 | -34,8290 | -1,558410 | |
| 52 | 9821,8721 | -1,4240 | -1,000000 | |
| 53 | -157,8195 | -22,5240 | -1,558410 | |
| 54 | -257,8030 | -1,1080 | -1,000000 | |
| 55 | -125,4426 | -52,2320 | -1,558410 | |
| 56 | -545,5697 | -1,2640 | -1,000000 | |
| 57 | -182,4345 | -19,6850 | -1,558410 | |
| 58 | 3491,0716 | -1,1000 | -1,000000 | |
| 59 | 0,0000 | -10,0000 | -1,558410 | |
| 60 | 0,0000 | -8,0420 | -1,000000 | |
| 61 | 0,0000 | 0,0000 | -1,000000 | |

Tabelle 4

| Fläche | K | C1 | C2 | C3 | C4 | C5 | C6 |
|---|---|---|---|---|---|---|---|
| 11 | 0 | 6,1332E-09 | -6,4063E-14 | -4,5499E-18 | -2,3621E-22 | 2,4653E-26 | -3,8399E-30 |
| 17 | 0 | 6,1332E-09 | -6,4063E-14 | -4,5499E-18 | -2,3621E-22 | 2,4653E-26 | -3,8399E-30 |
| 29 | 0 | 3,5716E-09 | -2,9481E-13 | 5,3916E-18 | 4,4070E-23 | 5,4581E-27 | -7,3136E-31 |
| 31 | 0 | -1,8810E-08 | 2,0385E-13 | -1,4483E-18 | -5,4964E-22 | 1,5447E-26 | 1,0845E-30 |
| 35 | 0 | -1,6228E-08 | -2,1449E-13 | -2,4296E-17 | 4,2715E-21 | -5,4242E-25 | 3,1678E-29 |

Tabelle 4   (fortgesetzt)

| Fläche | K | C1 | C2 | C3 | C4 | C5 | C6 |
|---|---|---|---|---|---|---|---|
| 42 | 0 | 1,7399E-08 | -7,3701E-13 | -3,4088E-17 | 1,1643E-21 | -4,5566E-26 | 1,2003E-30 |
| 47 | 0 | 3,9491E-09 | -5,1757E-14 | -4,2800E-18 | 6,4019E-22 | -1,0309E-25 | -7,9826E-30 |
| 52 | 0 | -1,7053E-08 | 8,0221E-13 | -8,4651E-17 | 7,3497E-21 | -5,0447E-25 | 9,0347E-30 |
| 57 | 0 | 1,3027E-07 | 4,8555E-12 | -2,2801E-15 | 3,5482E-19 | -5,9522E-23 | 1,5762E-26 |

**Patentansprüche**

1.  Katadioptrisches Projektionsobjektiv zur Abbildung eines in einer Objektebene (2) angeordneten Musters in eine Bildebene (4) unter Erzeugung eines reellen Zwischenbildes (3), wobei zwischen der Objektebene und der Bildebene ein katadioptrischer erster Objektivteil (5) mit einem Konkavspiegel (6) und eine Strahlumlenkeinrichtung (7) und hinter der Strahlumlenkeinrichtung ein dioptrischer zweiter Objektivteil (8) angeordnet ist, **dadurch gekennzeichnet, dass** der hinter einer letzten Spiegelfläche (9, 10) des katadioptrischen Objektivteils (5) beginnende zweite Objektivteil (8) mindestens eine Linse (17) aufweist, die zwischen der letzten Spiegelfläche (9, 10) und dem Zwischenbild (3) angeordnet ist.

2.  Projektionsobjektiv nach Anspruch 1, **dadurch gekennzeichnet, dass** das Zwischenbild (3) in einen Freiraum mit Abstand zur nächstliegenden optischen Komponente (17) angeordnet ist, und/oder dass das Zwischenbild (3) frei zugänglich ist.

3.  Projektionsobjektiv nach Anspruch 1 oder 2, **dadurch gekennzeichnet, dass** das Zwischenbild (3) in einem Abstand zur letzten Spiegelfläche (9, 10) der Strahlumlenkeinrichtung (7) angeordnet ist, der so bemessen ist, dass der Durchmesser von Strahlbündeln auf einer zur optischen Achse senkrecht stehenden Fläche im Schnittpunkt der letzten Spiegelfläche (9, 10) mit der optischen Achse (16) mindestens 10 % des Durchmessers des Konkavspiegels (6) beträgt und vorzugsweise zwischen 17 % und ca. 20 % dieses Durchmessers liegt.

4.  Projektionsobjektiv nach einem der vorhergehenden Ansprüche, **dadurch gekennzeichnet, dass** zwischen der letzten Spiegelfläche (9, 10) und dem Zwischenbild (3) positive Brechkraft angeordnet ist.

5.  Projektionsobjektiv nach einem der vorhergehenden Ansprüche, **dadurch gekennzeichnet, dass** objektseitig vor dem Zwischenbild (3) eine vordere Zwischenbildlinse (17) und bildseitig hinter dem Zwischenbild (3) eine hintere Zwischenbildlinse (21) angeordnet ist und dass die Zwischenbildlinsen in Bezug auf das Zwischenbild (3) derart im wesentlichen symmetrisch angeordnet sind, dass sich durch Linsenaufheizung verursachte asymmetrische Beiträge der Zwischenbildlinsen (17, 21) zu Bildfehlern, insbesondere Koma und/oder Verzeichnung, mindestens teilweise kompensieren.

6.  Projektionsobjektiv nach einem der vorhergehenden Ansprüche, **dadurch gekennzeichnet, dass** die dem Zwischenbild (3) nächste Linsenfläche des zweiten Objektivteils sphärisch ist, wobei vorzugsweise beide dem Zwischenbild (3) zugewandten Linsenflächen des zweiten Objektivteils sphärisch sind.

7.  Projektionsobjektiv nach einem der vorhergehenden Ansprüche, **dadurch gekennzeichnet, dass** der katadioptrische erste Objektivteil (5) einen Abbildungsmaßstab von $\beta_M > 0{,}95$ hat, wobei er vorzugsweise einen vergrößerten Abbildungsmaßstab ($\beta_M > 1$) hat.

8.  Projektionsobjektiv nach einem der vorhergehenden Ansprüche, **dadurch gekennzeichnet, dass** der katadioptrische erste Objektivteil (5) bezüglich der sphärischen Aberration derart korrigiert ist, dass für die sphärische Längsabberation SAL des ersten Objektivteils (5) folgende Bedingung $0 < |SAL/L| < 0{,}025$, wobei L der geometrische Abstand zwischen Objektebene (2) und Bildebene (4) ist.

9.  Projektionsobjektiv nach einem der vorhergehenden Ansprüche, **dadurch gekennzeichnet, dass** im katadioptrischen ersten Objektivteil (5) zwischen dem Strahlteiler und einer den Konkavspiegel (6) umfassenden Spiegelgruppe (12) mit mindestens einer Negativlinse (13, 14) eine Zwischenlinsengruppe (41) mit mindestens einer Linse angeordnet ist, wobei die Zwischenlinsengruppe (41) vorzugsweise mindestens eine Positivlinse (42) umfasst.

10. Projektionsobjektiv nach einem der vorhergehenden Ansprüche, **dadurch gekennzeichnet, dass** die Strahlumlenkeinrichtung (7) eine voll reflektierende erste Spiegelfläche (9) zur Umlenkung der von der Objektebene (2) kommenden Strahlung zum Konkavspiegel (6) und eine in einem Winkel zur ersten Spiegelfläche (9) angeordnete, voll reflektierende zweite Spiegelfläche (10) zur Umlenkung der von dem Konkavspiegel kommenden Strahlung zum zweiten Objektivteil (8) aufweist.

11. Projektionsobjektiv nach einem der vorhergehenden Ansprüche, **dadurch gekennzeichnet, dass** die Strahlumlenkeinrichtung (7) nur eine voll spiegelnde Spiegelfläche (9) aufweist, die vorzugsweise zur Reflexion der von dem Konkavspiegel (6) kommende Strahlung zum zweiten Objektivteil (8) angeordnet ist.

12. Projektionsobjektiv nach einem der vorhergehenden Ansprüche 1 bis 9, **dadurch gekennzeichnet, dass** die letzte Spiegelfläche eine polarisationsselektive Spiegelfläche ist, die insbesondere in einem Strahlteilerblock angeordnet ist.

13. Projektionsobjektiv nach einem der vorhergehenden Ansprüche, **dadurch gekennzeichnet, dass** zwischen der Objektebene (2) und der der Strahlumlenkeinrichtung (7) eine Linse (11) mit positiver Brechkraft angeordnet ist.

14. Projektionsobjektiv nach einem der vorhergehenden Ansprüche, **dadurch gekennzeichnet, dass** es im Bereich nahe vor der Systemblende (29) einen objektwärts gekrümmten, meniskusförmigen Luftraum (37) aufweist.

15. Projektionsobjektiv nach einem der vorhergehenden Ansprüche, **dadurch gekennzeichnet, dass** es bildseitig und vorzugsweise auch objektseitig telezentrisch ausgebildet ist.

16. Projektionsobjektiv nach einem der vorhergehenden Ansprüche, **dadurch gekennzeichnet, dass** es für Ultraviolettlicht aus einem Wellenlängenbereich zwischen ca. 120 nm und ca. 260 nm ausgelegt ist, insbesondere für Arbeitswellenlängen von ca. 157 nm oder ca. 193 nm.

17. Projektionsbelichtungsanlage für die Mikrolithographie, **dadurch gekennzeichnet, dass** sie ein katadioptrisches Projektionsobjektiv (1) gemäß einem der vorhergehenden Ansprüche umfasst.

18. Verfahren zur Herstellung von Halbleiterbauelementen und anderen feinstrukturierten Bauteilen mit folgenden Schritten:

   - Bereitstellung einer Maske mit einem vorgegebenen Muster;
   - Beleuchtung der Maske mit Ultraviolettlicht einer vorgegebenen Wellenlänge; und
   - Projektion eines Bildes des Musters auf ein im Bereich der Bildebene eines Projektionsobjektives angeordnetes lichtempfindliches Substrat mit Hilfe eines katadioptrischen Projektionsobjektives gemäß einem der Ansprüche 1 bis 16.

Fig. 1

EP 1 260 845 A2

Fig. 2

Fig. 3

Fig.4

EP 1 260 845 A2

Fig. 5